# EUROPEAN PATENT SPECIFICATION

(11) **EP 0 612 868 B1**
(45) Date of publication and mention of the grant of the patent: **22.07.1998**
(21) Application number: 94102670.0
(22) Date of filing: 22.02.1994
(51) Int. Cl.: C30B 25/02, C30B 29/04

(54) **Single crystal diamond and process for producing the same**
Einkristall-Diamant und Verfahren zu seiner Herstellung
Diamant monocristallin et procédé de sa production

(30) Priority: 22.02.1993 JP 32221/93
(43) Date of publication of application: 31.08.1994
(73) Proprietor: SUMITOMO ELECTRIC INDUSTRIES, LTD., Osaka-shi, Osaka 541 (JP)
(72) Inventor: Tsuno, Takashi, c/o Itami Works of Sumitomo, Itami-shi, Hyogo (JP); Imai, Takahiro, c/o Itami Works of Sumitomo, Itami-shi, Hyogo (JP); Fujimori, Naoji, c/o Itami Works of Sumitomo, Itami-shi, Hyogo (JP)
(74) Representative: Grünecker, Kinkeldey, Stockmair & Schwanhäusser Anwaltssozietät

(56) References cited:
- EP-A- 0 386 726
- WO-A-92/22689
- PATENT ABSTRACTS OF JAPAN vol. 15, no. 328 (C-860)21 August 1991 & JP-A-03 126 697 (SUMITOMO ELECTRIC INDUSTRIES LTD) 29 May 1991
- APPL. PHYS. LETTERS vol. 61, no. 26 , 28 December 1992 , NEW YORK NY USA pages 3124 - 3126 PARIKH ET AL 'Single crystal diamond plate lift off'

## Description

### BACKGROUND OF THE INVENTION

The present invention relates to a process for producing diamond, more particularly, to a process for producing large diamond single crystals that are useful as semiconductor materials, electronic parts, optical parts, cutting tools, abrasive tools, precision tools, etc.

Diamond has many advantageous properties such as high hardness, high heat conductivity, high light transmittance and a wide band gap and, hence, it is used extensively as a material of various kinds of tools, optical parts, semiconductors and electronic parts and its importance is expected to grow in the years to come. In the past, naturally produced diamonds were used in engineering applications but today most of the industrial diamonds used are synthetic. In commercial plants, all diamond single crystals are currently synthetized at pressures in the range higher than several tens of thousands of atmosphere where they are stable. Since pressure vessels which are capable of creating such ultrahigh pressures are not only very expensive but also limited in size, the applicability of the high-temperature, high-pressure method to the production of large synthetic diamond single crystals is limited. As for the type Ib diamond which is yellow in the presence of impurity nitrogen (N), crystals with sizes of the order of 1 cm have been synthesized by the high-pressure method and are already sold on the market; however, this would be the limit in the production of large synthetic Ib diamonds. The size of pure, clear and colorless type IIa diamond crystals that can be synthesized today is limited to even smaller values (less than a few millimeters) with the exception of natural products.

In addition to the high-pressure process, there is another method that has been established as a technique for diamond synthesis and it is the vapor-phase process. Crystals of comparatively large areas (from a few to ten centimeters) have been synthetized by this process and they are usually in the form of a polycrystalline film. However, if diamond is to be used in ultrahigh precision tools, optical parts and semiconductors that require very smooth surfaces, single-crystal rather than polycrystalline quality is necessary. Under the circumstances, studies have heretofore been made to develop a method that enables single crystal diamond to grow epitaxially in the vapor-phase process. There are two approaches for effecting epitaxial growth; homoepitaxy which causes a substance to grow on a substrate made of a similar substance, and heteroepitaxy in which a substance of interest is grown on a substrate made of a dissimilar substance.

In homoepitaxy, diamond of high purity is grown epitaxially from the vapor phase on a type Ib diamond substrate that has been prepared by high-pressure synthesis and this enables the production of type IIa single diamond crystals that are larger than the high-pressure type IIa diamond. It is also anticipated that diamond having only low angle grain boundaries can be produced by integral diamond growth on a plurality of diamond substrates or grains that are oriented in the same crystal orientation (see Unexamined Japanese Patent Publication (kokai) No. Hei 3-075298, and M.W. Geis, H.I. Smith, A. Argoitia, J. Angus, G.H.M. Ma, J.T. Glass, J. Butler, C.J. Robinson and R. Pryor: Appl. Phys. Lett., Vol. 58 (1991), p. 2485).

Successful cases of heteroepitaxial growth have so far been reported for cubic boron nitride (cBN), silicon carbide, silicon, nickel, cobalt, etc. (Unexamined Japanese Patent Publication (kokai) Nos. Sho 63-224225, Hei 2-233591 and Hei 4-132687). If the technique of heteroepitaxial growth on single crystals in which large-area substrates are readily available were established, one could yield large-area single crystal diamond and, hence, there is good reason to expect commercial application of heteroepitaxial growth. In fact, however, even the substrates on which successful cases of heteroepitaxial growth have been reported suffer from the problem of lattice constant mismatch from diamond. Hence, the quality of diamond films that are produced by heteroepitaxial growth is much inferior to the quality obtainable by homoepitaxial growth.

Under the circumstances, one may well assume that vapor-phase homoepitaxy on a single crystal diamond substrate prepared by the high-pressure synthesis method would be a useful approach. As already mentioned above, according to this method, large IIa crystals which are difficult to synthesize by the high-pressure process can be produced on a type Ib diamond substrate which is synthesized by the high-pressure method. The problem here is in association with the removal of the substrate. Consider, for example, the case of using type Ib diamond with a view to producing a type IIa diamond crystal measuring 1 cm × 1 cm. If this diamond crystal is to be used as an optical part, the type IIa diamond film formed by vapor-phase deposition has to be rendered free from the Ib substrate by a certain method, which is either to separate between the epitaxial film and the substrate or to remove the substrate per se. The first method may be effected by slicing. However, the larger the area of the diamond to be yielded as the final product, the greater the thickness of the epitaxial diamond that is necessary and the chance of success in slicing is reduced. Under the circumstances, slicing is no longer possible on the epitaxial film and substrate combination if its size is 1 cm × 1 cm and one has to rely on the second approach of removing the substrate per se. While several procedures are known to implement this approach, such as polishing with diamond abrasive particles, reaction with the iron surface followed by removal of the layer that has undergone the reaction (see, for example, Unexamined Japanese Patent Publication (kokai) No. Hei 2-26900), and exposure to an ion beam (Unexamined Japanese Patent Publication (kokai) No. Sho 64-68484). However, these methods are quite time-consuming. In addition, they suffer from serious economic disadvantage in that the substrate synthesized by the high-pressure process is not reusable.

Parikh et al. reported a method that consisted of implanting accelerated (several MeV) oxygen (O) ions into the surface of a bulk diamond crystal and then heating the crystal, whereby a single crystal diamond film with a thickness of the micron order could be lifted from the substrate's surface (see N.R. Parikh, J.D. Hunn, E. McGucken, M.L. Swanson, C.W. White, R.A. Rudder, D.P. Malta, J.B. Posthill and R.J. Markunas: Appl. Phys. Lett. 61 (1992), 3124). However, this method requires a very expensive ion implantation apparatus; in addition, the separated thin diamond layer does not have good crystallinity because of the accumulated damage due to the passage of ion beams.

Tomikawa et al. proposed a method that consisted of causing nickel (Ni) and diamond to grow heteroepitaxially in that order on a diamond substrate and then dissolving the intermediate Ni layer so as to yield an epitaxial diamond film independent of the substrate (Japanese Patent Application No. Hei 1-266825). This method is also based on the nonpreferable diamond heteroepitaxial technology and still unsatisfactory in terms of film quality. Under the circumstances, there has been a strong need to develop a method by which a film of good crystallinity was grown epitaxially on a single diamond crystal by vapor-phase synthesis and in which the epitaxial diamond film and the substrate diamond could be separated without damage or without deterioration in their crystallinity so that the substrate could be used again.

The existing technology has the problem that even if a single diamond crystal of high quality is grown by epitaxially growing high-purity and large-area diamond, the epitaxial diamond cannot be used per se without removing the substrate in a form that is no longer suitable for reuse. Under the circumstances, there has existed a strong need to develop a method by which epitaxial growth of diamond with good crystallinity could be done on a diamond single crystal by vapor-phase synthesis and in which the epitaxial diamond film and the substrate diamond could be separated without damage.

### SUMMARY OF THE INVENTION

The present invention has been made to solve the above described problems and has been made on the finding that in the process of epitaxial growth of diamond from the vapor phase on a single crystal diamond substrate, separation between the diamond substrate and the epitaxial diamond layer can be facilitated by forming a less concentrated diamond region at or near the interface between the two parts.

### BRIEF DESCRIPTION OF THE DRAWINGS

Fig. 1a is a top view showing the sample prepared in accordance with an embodiment of the present invention;
Fig. 1b is a side view of the sample of Fig. 1a;
Fig. 2 is a side view showing diagrammatically the interior of the sample of Fig. la as cut through a section;
Fig. 3 is a side view showing how the sample of Fig. 1a splits in two parts;
Fig. 4 is a side view showing how the sample prepared in accordance with another embodiment of the present invention splits in two parts;
Fig. 5 is a side view showing how the sample prepared in a comparative method splits in two parts.

### DETAILED DESCRIPTION OF THE PREFERRED EMBODIMENTS

The present invention as described in the claims will now be described in detail in the following pages.

First, the operations of the present invention will be described.

If a certain single crystal material is cleaved in an orientation of its inherent cleavage, cracking usually progresses in the direction of cleavage and, hence, the crystal will split in two parts along a substantially flat plane. Since the cleavage plane of diamond is represented by the form {111}, it cannot be separated along the simple {100} or {110} plane. If a diamond single crystal contains inclusions or cracks and when cracking that propagates through the crystal reaches one of the inclusions or already present cracks, the path of the cracking is refracted; this finding was the basis for the accomplishment of the present invention. Thus, the operating theory of the present invention is that voids or inclusions are incorporated in single crystal diamond along a predetermined plane or curved surface and that then the diamond is split in two parts along that plane or curved surface. All that is needed for the present invention is that a region where the concentration of diamond is low is provided deliberately by incorporating hollow portions.

The present inventors also found that in the process of homoepitaxial growth of a single crystal diamond on a single crystal diamond substrate, the single crystal diamond grew in such a way as to ride over the areas where diamond was only sparsely present and which consisted of voids, and that the parts of crystal meeting on the voids formed a complete integral single crystal.

The areas where diamond is populated less densely can be formed by forming a pattern of asperities in the surface of a diamond substrate, with the depth and width of the recesses being so determined that they could not be completely filled with the film of single crystal diamond to be formed. Such recesses can be formed by etching with a laser beam or an ion beam. Of the two etching techniques, the use of a focused laser beam in atmospheric air is a comparatively convenient procedure. A suitable laser light source is a pulsed laser that produces pulses at periods not longer than 1 msec and that permits lens or the like to focus the beam to an energy of 0.5 J/cm² and more. A CO₂ laser, a YAG laser, an excimer laser and the like can be used.

The pattern of asperities to be formed may be groove-like, circular or otherwise shaped. It should, however, be noted that if the width or diameter of recesses is less than 2 µm, there is high likelihood that any cracks will propagate through the crystal in an unspecified and indefinite direction; to avoid this problem, the recesses to be formed should preferably have a minimum width or diameter of at least 2 µm. Similarly, the depth of the recesses should preferably be at least 3 µm. It is also necessary that the portion where the voids presents in the largest cross-sectional area, occupies at least 5% of the cross section through which fracture is anticipated to occur. In order to assure easy mechanical splitting, the largest cross-sectional areas preferably account for at least 25% of the cross section where fracture would occur. In the case where recesses are to be formed like grooves or the dissimilar substance is to be formed in stripes, such grooves or stripes may extend linearly in a direction perpendicular to the {111} plane of the substrate crystal and this is preferred for the purpose of insuring that cleavage will progress in the desired direction.

In order to split the single crystal diamond along the areas where diamond is present only sparsely, a certain force must be applied. In the case where voids are formed within the single crystal diamond, it is convenient to form a slit on a lateral side of the single crystal near the site where voids are present and to exert an impact through the blade of a superhard material that is inserted into the slit.

The single crystal diamond substrate that can be used in the practice of the present invention is in no way limited as regards the plane index and any planes including {111}, {110} and {100} may be employed. For effecting vapor-phase synthesis to perform epitaxial growth of diamond, every known process such as thermal CVD, plasma-assisted CVD and combustion flame techniques may be applied.

Next, the present invention will be described more concretely with refering to the examples and the accompanying drawings.

### Example 1

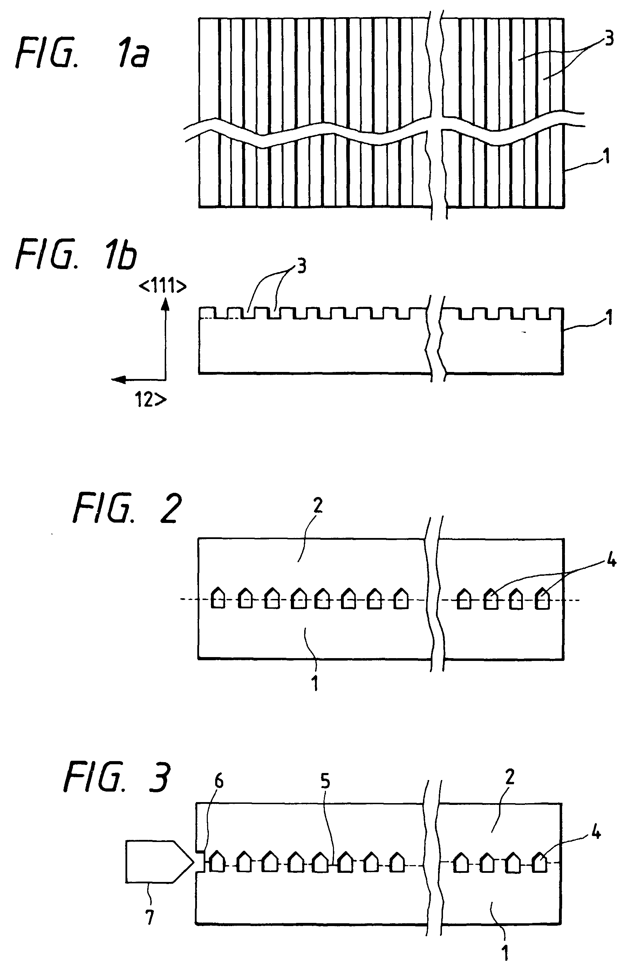

In Example 1, a substrate was made of a disk prepared by slicing and polishing a natural type IIa single diamond crystal. The plane index of the substrate was {111}. Slits were formed in the surface of the substrate by a pulsed YAG laser beam with a wavelength of 1.06 µm, which was focused by a cylindrical convex lens to produce a linear beam, so that the surface of the substrate was processed into linear grooves in a striped pattern as shown in Figs. 1a and 1b. The grooves were 60 µm deep and individual ridges and grooves each had a width of 60 µm. Hydrogen gas containing 1% methane was supplied over the substrate at a pressure of (6000 Pa) 45 Torr and an epitaxial film was grown in a thickness of 300 µm by a known microwave plasma-assisted CVD technique. Subsequent examination of a cross section of the sample revealed its interior as shown in Fig. 2; the estimated cross-sectional area of the voids that were present in a plane as cut along the dashed line accounted for 45% of the same plane.

Using a YAG laser, a slit 40 µm deep was formed on a lateral side of the sample in an area near the interface between the epitaxially grown layer and the substrate. A sharp superhard alloy blade was inserted into the slit from the side of the sample as shown in Fig. 3. When an external force was exerted through the blade, the sample split in two portions along the dotted line (see Fig. 3) that extended to the other side of the sample. Splitting or cracking did not occur in any other directions. The voids occupied 43% of the cross-sectional area of the split fracture. Examination by X-ray topography verified that the separated epitaxial layer was entirely composed of single crystals. In Raman spectroscopy, the diamond had a half-width of 1.7 cm⁻¹ for a scattering intensity of 1,332 cm⁻¹ and this shows that the diamond had better crystallinity than the natural type IIa single crystal substrate which had a half-width of 3.2 cm⁻¹. The shape of the single crystal substrate that remained after separation was found to be virtually the same as before the epitaxial growth of diamond. Hence, using the substrate, one more cycle of epitaxial growth was performed and splitting was done; epitaxial single crystal diamond of the same quality was yielded, thus verifying the reusability of the substrate.

### Comparative Example 1

The procedure of Example 1 was repeated using a {111} diamond substrate, except that grooves were not formed by working with a YAG laser. As in Example 1, an epitaxial film was grown in a thickness of 300 µm by a known microwave plasma-assisted CVD technique. When an external force was exerted on the sample from a lateral side, cleavage occurred along a line extending to the other side of the sample; however, it was found that the cleavage occured at a place slipped from the interface between the epitaxial layer and the substrate by a maximum of 100 µm.

### Example 2

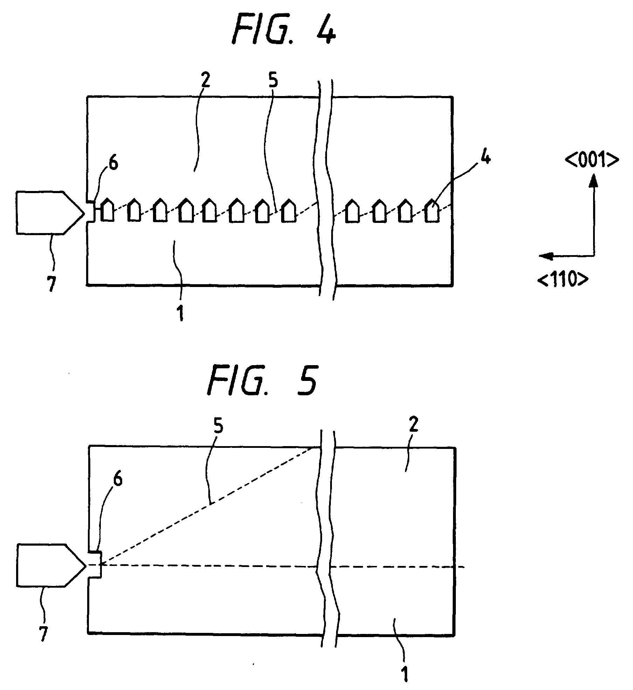

In Example 2, a substrate was made of a disk prepared by slicing and polishing a synthetic type Ib single diamond crystal that was produced by the high-pressure process. The substrate was 1 mm thick and the deviation for all crystal planes from the {100} surface was within one degree. Grooves were formed in the surface of the substrate as in Example 1 by working with a linear focused beam from an XeCl excimer laser operating at a wavelength of 308 nm. The grooves were formed to be parallel to the {110} plane. They were 100 µm deep and the ridges and grooves had respective widths of 50 µm and 100 µm. An epitaxial layer was grown in a thickness of 500 µm on the substrate under the same conditions as used in Example 1. A sharp-edged metal section was held against a lateral side of the sample as shown in Fig. 4 and a force was exerted through the metal section, whereupon the sample split in two portions along the dotted line that extended to the other side of the sample. Splitting or cracking did not occur in any other directions.

### Comparative Example 2

The procedure of Example 2 was repeated using a {100} diamond substrate, except that grooves were formed by working with an XeCl excimer laser. As in Example 2, an epitaxial film was grown in a thickness of 300 µm by a known microwave plasma-assisted CVD technique. When an external force was exerted to the sample from a lateral side, cleavage occurred in an area that was far away from the interface between the epitaxial layer and the substrate as shown in Fig. 5.

According to the present invention, an epitaxial layer of high quality is formed on a single crystal diamond substrate by homoepitaxial growth and only the grown epitaxial layer can readily be isolated from the substrate, which, if desired, may be used again. Thus, diamond single crystals of high quality can be manufactured efficiently and supplied to the market at low price.

## Claims

1. A single crystal diamond that is produced by a vapor-phase epitaxial growth method on a single crystal diamond substrate, comprising linear voids occupying at least 5%, in terms of cross-sectional area, and having a width of at least 2 µm, said voids being formed at or near an interface between said single crystal diamond substrate and said epitaxially grown diamond.

2. A process for producing the single crystal diamond on a single crystal diamond substrate of claim 1, comprising the steps of:
forming linear recesses in a surface of said single crystal diamond substrate, said recesses having a width of at least 2 µm and occupying at least 5% of an area of said surface; and
epitaxially growing said single crystal diamond on said substrate by a vapor-phase growth method.

3. A process for producing a single crystal diamond comprising the steps for producing single crystal diamond on a single crystal diamond substrate as claimed in claim 2, and further comprising the step of splitting said epitaxially grown single crystal diamond from said single crystal diamond substrate along regions where said voids are present.

## Patentansprüche

1. Einkristall-Diamant, der durch ein Gasphasenepitaxie-Wachstumsverfahren auf einem Einkristall-Diamantsubstrat hergestellt wird, mit linearen Hohlräumen, die wenigstens 5 % in bezug auf die Querschnittsfläche einnehmen und eine Breite von wenigstens 2 µm aufweisen, wobei die Hohlräume an oder in der Nähe eines Übergangs zwischen dem Einkristall-Diamantsubstrat und dem epitaktisch gewachsenen Diamant ausgebildet sind.

2. Ein Verfahren zur Herstellung des Einkristall-Diamants auf einem Einkristall-Diamantsubstrat nach Anspruch 1, mit den folgenden Schritten:
Ausbilden linearer Ausnehmungen in einer Oberfläche des Einkristall-Diamantsubstrats, wobei die Ausnehmungen eine Breite von wenigstens 2 µm aufweisen und wenigstens 5 % eines Gebiets der Oberfläche einnehmen; und
epitaktisches Wachsen des Einkristall-Diamants auf dem Substrat durch ein Gasphasen-Wachstumsverfahren.

3. Ein Verfahren zur Herstellung eines Einkristall-Diamants mit den Schritten des Herstellens eines Einkristall-Diamants auf einem Einkristall-Diamantsubstrat wie in Anspruch 2 beansprucht und weiter mit dem Schritt des Abspaltens des epitaktisch gewachsenen Einkristall-Diamants von dem Einkristall-Diamantsubstrat entlang von Bereichen, wo die Hohlräume vorhanden sind.

## Revendications

1. Diamant monocristallin produit par un procédé de croissance épitaxiale en phase vapeur sur un substrat de diamant monocristallin, comprenant des vides linéaires occupant au moins 5 %, par rapport à la section, et ayant une largeur d'au moins 2 µm, ces vides étant formés à l'interface du substrat de diamant monocristallin et du diamant formé par croissance épitaxiale ou près de cette interface.

2. Procédé de production de diamant monocristallin sur un substrat de diamant monocristallin selon la revendication 1, comprenant les étapes suivantes :
la formation de cavités linéaires dans une surface du substrat de diamant monocristallin, les cavités ayant une largeur d'au moins 2 µm et occupant au moins 5 % de l'étendue de la surface, et
la croissance épitaxiale du diamant monocristallin sur le substrat par un procédé de croissance en phase vapeur.

3. Procédé de production de diamant monocristallin comprenant les étapes de production d'un diamant monocristallin sur un substrat de diamant monocristallin selon la revendication 2, et comprenant en outre une étape de séparation du diamant monocristallin formé par croissance épitaxiale du substrat de diamant monocristallin le long de régions dans lesquelles des vides sont présents.
